(19) Europäisches Patentamt

European Patent Office

Office européen des brevets

(11) **EP 0 734 048 B1**

(12) **FASCICULE DE BREVET EUROPEEN**

(45) Date de publication et mention
de la délivrance du brevet:
**10.08.2005 Bulletin 2005/32**

(51) Int Cl.⁷: **H01J 37/34**, H01J 37/32

(21) Numéro de dépôt: **96870034.4**

(22) Date de dépôt: **22.03.1996**

(54) **Procédé et dispositif pour revêtir ou nettoyer un substrat**

Verfahren und Vorrichtung zur Beschichtung oder Reinigung eines Substrats

Procedure and device for coating or cleaning a substrate

(84) Etats contractants désignés:
**AT BE CH DE DK ES FI FR GB GR IE IT LI LU NL PT SE**

(30) Priorité: **24.03.1995 BE 9500260**

(43) Date de publication de la demande:
**25.09.1996 Bulletin 1996/39**

(73) Titulaire: **USINOR**
**92800 Puteaux (FR)**

(72) Inventeur: **Vanden Brande, Pierre**
**1040 Bruxelles (BE)**

(74) Mandataire: **Quintelier, Claude et al**
**Gevers & Vander Haeghen,**
**Intellectual Property House,**
**Brussels Airport Business Park**
**Holidaystraat 5**
**1831 Diegem (BE)**

(56) Documents cités:
**EP-A- 0 420 117        EP-A- 0 563 609**
**DE-A- 4 230 291        DE-A- 4 239 843**
**US-A- 4 986 214**

## Description

L'invention concerne un procédé pour la formation par pulvérisation cathodique d'un revêtement sur un substrat, ledit substrat étant placé dans une chambre qui est ensuite amenée et maintenue durant ladite formation à une pression inférieure à 1 Pa et dans laquelle un plasma est généré, un champ électrique étant appliqué dans ladite chambre entre une cathode à pulvériser et une anode, un champ magnétique sensiblement perpendiculaire au champ électrique étant également appliqué au moins au niveau de la cathode de manière à réaliser un circuit de confinement magnétique des électrons, et une zone de résonance cyclotron des électrons étant créée à proximité de la cathode en appliquant un champ électromagnétique dans la gamme de fréquences micro-ondes et dont la fréquence d'ondes correspond à la fréquence cyclotron des électrons dans le champ magnétique.

L'invention concerne également un procédé de nettoyage par bombardement ionique d'un substrat, ledit substrat étant placé dans une chambre qui est ensuite amenée et maintenue durant ledit nettoyage à une pression inférieure à 1 Pa et dans laquelle un plasma est généré, un champ électrique étant appliqué dans ladite chambre entre une anode et ledit substrat servant de cathode, un champ magnétique sensiblement perpendiculaire au champ électrique étant également appliqué au moins au niveau de la cathode de manière à réaliser un circuit de confinement magnétique des électrons, et une zone de résonance cyclotron des électrons est créée à proximité de la cathode en appliquant un champ électromagnétique dans la gamme de fréquences micro-ondes et dont la fréquence d'ondes correspond à la fréquence cyclotron des électrons dans le champ magnétique.

L'invention concerne enfin un dispositif pour l'application du procédé.

De tels procédés et dispositifs sont connus de la demande de brevet européen n°0563609. Ces procédés sont généralement appelés "plasma sputtering" ou "plasma etching" lorsqu'il s'agit de revêtir ou de nettoyer un substrat. La vitesse de dépôt sur le substrat ou la vitesse à laquelle le substrat est nettoyé est, en pulvérisation cathodique, directement liée au taux d'ionisation dans la décharge et donc à la densité du courant de cible ou de cathode. La densité de courant maximale que l'on peut atteindre pour des raisons de stabilité du plasma dépend fortement des conditions d'excitation du gaz formant le plasma. Ainsi la présence d'un champ magnétique appliqué au moins au niveau de la cathode et qui permet de réaliser un circuit de confinement magnétique des électrons offre la possibilité d'augmenter la densité de courant de cible et/ou de diminuer la tension de cible.

La présence du champ électromagnétique dans la gamme de fréquences micro-ondes appliquée simultanément avec le champ magnétique crée un phénomène de résonance cyclotron des électrons qui permet d'accroître leur énergie. Puisque la fréquence d'onde correspond à la fréquence cyclotron des électrons dans le champ magnétique, l'énergie du champ électromagnétique sera au moins partiellement absorbée par ces derniers. Leur rayon de giration augmente ainsi avec la croissance de l'énergie cinétique permettant une amplification des collisions ionisantes. Ainsi donc le taux d'ionisation va s'accroître ce qui permettra à la vitesse de dépôt de s'accroître, augmentant ainsi le rendement du procédé.

Un inconvénient du procédé ou du dispositif connu est que lorsque la puissance du champ électromagnétique est augmentée, la densité du plasma augmente également et les micro-ondes injectées dans le champ magnétique sont réfléchies vers la source génératrice de micro-ondes par le plasma à haute densité. Ceci est notamment le cas lorsque les micro-ondes sont introduites au moyen de guides d'ondes conventionnels dans la zone de décharge où la résonance cyclotronique des électrons est possible. Le couplage de l'énergie du champ électromagnétique est ainsi limité en-dessous d'un seuil qui correspond à une densité de plasma maximale de l'ordre de $10^{12}$ cm$^{-3}$.

L'invention a pour but de réaliser un procédé de formation par pulvérisation cathodique ou de nettoyage par bombardement ionique d'un substrat, ainsi qu'un dispositif pour l'application de ce procédé permettant des densités de plasma supérieures à $10^{12}$ cm$^{-3}$

Les procédés et dispositifs selon l'invention sont définis dans les revendications 1 à 5.

A cette fin, un procédé suivant l'invention est caractérisé en ce que la fréquence d'onde des micro-ondes appliquée est supérieure à 2,45 GH$_z$ et inférieure à 45 GH$_z$, en particulier 28,5 GH$_z$, ledit plasma étant généré de telle façon à obtenir une densité supérieure à $10^{12}$ cm$^{-3}$. En appliquant une fréquence d'onde supérieure à 2,45 GH$_z$, le plasma devient "transparent" pour le champ électromagnétique et ne réfléchira plus le rayonnement des micro-ondes qui traverseront donc le plasma. En particulier une densité de plasma de $10^{13}$ cm$^{-3}$ correspond à une fréquence plasma de 28,5 GH$_z$.

Il faut noter que EPA 0420117 mentionne des plages d'utilisation d'un magnétron situées entre 300 MH$_z$ et 95 GH$_z$. Toutefois, ce dernier document ne donne pas pour autant une indication à l'homme du métier d'ajuster, en fonction du type de plasma, la fréquence des micro-ondes. Malgré le fait que ce document cite les possibilités d'un magnétron, il n'enseigne pas une solution au problème de réflexion des micro-ondes. Ce même document divulgue un arrangement de sources de micro-ondes permettant de produire un plasma sur une grande superficie dans une position constante pour une longue période de temps. Pour obtenir un tel plasma il y est précisé de produire une pluralité de micro-ondes ayant des champs électriques qui ont des directions qui diffèrent l'une par rapport à l'autre. Ce document reste silencieux quant à la création d'une zone de résonance cyclotron des étectrons et à un plasme de haute densité.

Une forme particulière de réalisation d'un dispositif suivant l'invention est caractérisée en ce qu'elle comporte des moyens pour limiter la diffusion du plasma en dehors de ladite zone de résonance cyclotron dans la direction de ladite source, ledit générateur de plasma étant agencé pour produire un plasma ayant une densité supérieure à $10^{12}$ cm$^{-3}$. En limitant la diffusion du plasma, le transfert de l'énergie des micro-ondes n'est pas gênée dans son trajet vers la zone de résonance ce qui permet alors d'augmenter la densité du plasma.

Une forme préférentielle de réalisation d'un dispositif suivant l'invention est caractérisée en ce que lesdits moyens pour limiter la diffusion du plasma comportent des éléments en forme d'écran électriquement isolés entre eux et par rapport à un guide d'onde reliant ladite source à ladite zone de résonance, lesdits éléments étant disposés dans le guide d'onde perpendiculairement aux lignes de champ électrique dudit champ électromagnétique. De tels éléments sont faciles à monter et limitent de façon efficace la diffusion du plasma.

Une autre forme préférentielle d'un dispositif suivant l'invention est caractérisée en ce qu'entre la source de micro-ondes et la chambre est aménagée une zone tampon destinée à protéger la source de micro-ondes d'une contamination par la substance pulvérisée de la cathode.

L'invention sera maintenant décrite plus en détail à l'aide des dessins, dans lesquels:

La figure 1 représente schématiquement le dispositif de formation d'un revêtement suivant l'état de la technique;
La figure 2 illustre schématiquement la trajectoire d'un électron dans la chambre;
La figure 3 montre deux courbes illustrant le déplacement de la caractéristique électrique mesuré entre cathode et anode en fonction de la puissance P appliquée par rayonnement électromagnétique micro-ondes;
La figure 4 représente schématiquement un dispositif pourvu d'une zone tampon.
La figure 5 respectivement 7 représente schématiquement un dispositif suivant l'invention pourvu de moyens pour limiter la diffusion du plasma; et
La figure 6 représente schématiquement un dispositif pourvu d'antennes de couplage.
Les figures 8 et 9 illustrent le phénomène de diffusion du plasma.

Dans les dessins, une même référence a été attribuée à un même élément ou à un élément analogue.

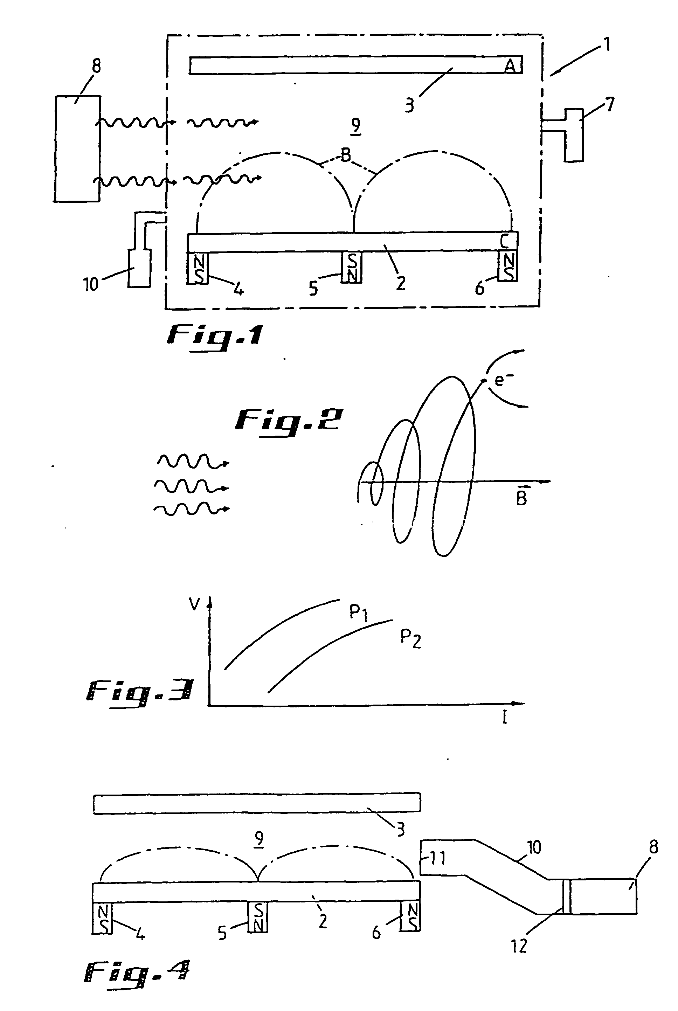

Le dispositif illustré à la figure 1 comporte une chambre 9 dans laquelle sont disposées une cathode 2 et une anode 3. La cathode et l'anode sont montées sur des supports (non repris dans le dessin) de façon à pouvoir les remplacer facilement. La cathode et l'anode sont reliées de façon conventionnelle à une source de tension électrique, également non représentée dans le dessin, afin d'établir un champ électrique entre cathode et anode. Lorsque le dispositif est utilisé pour revêtir un substrat par pulvérisation cathodique, l'anode est formée de préférence par le substrat à revêtir. Au cas où l'anode ne forme pas le substrat à revêtir, l'anode est située dans l'espace entre la cathode et le substrat à revêtir.

Il va de soi que d'autres formes de réalisation sont possibles, comme, par exemple, que l'anode soit une anode classique et le substrat soit introduit dans la chambre entre cathode et anode.

Lorsque le dispositif est utilisé pour nettoyer par bombardement ionique un substrat, le substrat est constitué de préférence par la cathode.

La chambre est reliée à une source 7 de gaz, par exemple du gaz argon ou un mélange de gaz éventuellement réactif. La source de gaz sert à injecter du gaz dans la chambre et à générer ainsi un plasma dans le volume entre cathode et anode.

Des aimants permanents 4, 5, 6 sont placés au voisinage de la cathode 2. Ces aimants permettent de créer dans la chambre et au moins au niveau de la cathode un champ magnétique sensiblement perpendiculaire au champ électrique. Les lignes de champs du champ magnétique sont reprises à la figure 1 et désignées par la lettre B. Le champ magnétique est appliqué de telle façon à réaliser dans la chambre entre cathode et anode un circuit de confinement magnétique des électrons. Ce champ magnétique permet d'atteindre une densité de courant de cible beaucoup plus élevée que celle atteinte par un champ électrique seul.

Dans le champ d'induction magnétique, les électrons vont décrire une trajectoire de forme hélicoïdale à rayon constant pour autant que l'intensité de ce champ soit elle-même sensiblement constante. Les électrons décrivent ainsi une trajectoire plus longue dans la chambre, ce qui offre une probabilité plus élevée de collision entre un électron et une molécule ou atome de gaz et donc une croissance du taux d'ionisation.

Au lieu d'utiliser des aimants permanents, il est également possible de créer le champ magnétique à l'aide de bobines dans lesquelles circule un courant électrique. Les bobines sont alors placées au niveau de la cathode.

Afin de créer une basse pression à l'intérieur de la chambre, le dispositif comporte une pompe 10 reliée à la chambre. Durant la mise en oeuvre du procédé suivant l'invention, la chambre est ainsi maintenue à une pression inférieure à 1 Pa.

Le dispositif suivant l'invention comporte également une source 8 génératrice de micro-ondes. Cette source est agencée pour introduire à travers une fenêtre ou par l'intermédiaire d'une antenne, un champ électromagnétique dans la gamme de la fréquence micro-onde dans la chambre. Pour obtenir une zone de résonance cyclotron des électrons (ECR) à proximité de la cathode, il convient que la fréquence f d'onde du champ électromagnétique émises par le générateur de micro-ondes corresponde à la fréquence cyclotron des électrons dans le champ magnétique, c'est-à-dire :

$$f = \frac{eB}{2\pi m}$$

où respectivement e et m représentent la charge et la masse de l'électron, B étant la grandeur du champ magnétique. Ainsi, par exemple, pour un champ magnétique B = 875 Gauss, la valeur de la fréquence sera : f = 2,45 . $10^9$ Hz.

De préférence, le champ électromagnétique est polarisé dans le même sens que celui de la rotation d'un électron dans le champ magnétique. L'énergie ainsi introduite par les micro-ondes peut être pratiquement absorbée totalement.

Le fait d'induire un champ électromagnétique dans la gamme de fréquences micro-ondes dans la chambre aura pour conséquence que, si la fréquence d'onde correspond à la fréquence de giration de l'électron dans le champ magnétique, la trajectoire de forme hélicoïdale à rayon constant que décrit l'électron va se transformer en une trajectoire en forme de spirale dont le rayon croît à chaque révolution car les électrons augmentent leur énergie cinétique par absorption de l'énergie électromagnétique lors du processus de résonance cyclotron. Une telle trajectoire est illustrée à la figure 2. Ce phénomène permet un accroissement du nombre de collisions ionisantes dans la chambre. L'augmentation du nombre de collisions ionisantes entre les électrons et les molécules ou atomes de gaz conduit à une augmentation du taux d'ionisation du plasma. Etant entendu que le circuit de confinement magnétique des électrons et la zone de résonance cyclotron des électrons sont à proximité de la cathode, c'est à cet endroit que l'augmentation du taux d'ionisation du plasma sera réalisé.

La croissance du taux d'ionisation dans le plasma ainsi obtenue permet d'atteindre une densité de courant cathodique beaucoup plus élevée que celle obtenue par la pulvérisation cathodique magnétron classique ou par un nettoyage par bombardement ionique magnétron classique. Le procédé permet donc à courant constant de diminuer l'impédance de la décharge et donc de réduire les pertes causées par l'échauffement du substrat dues au bombardement ionique. On peut ainsi atteindre une densité de courant de 300 mA/$cm^2$, ce qui en pulvérisation cathodique correspond à une vitesse de dépôt dix fois supérieure aux vitesses de dépôt maximales réalisées à ce jour en pulvérisation cathodique magnétron classique.

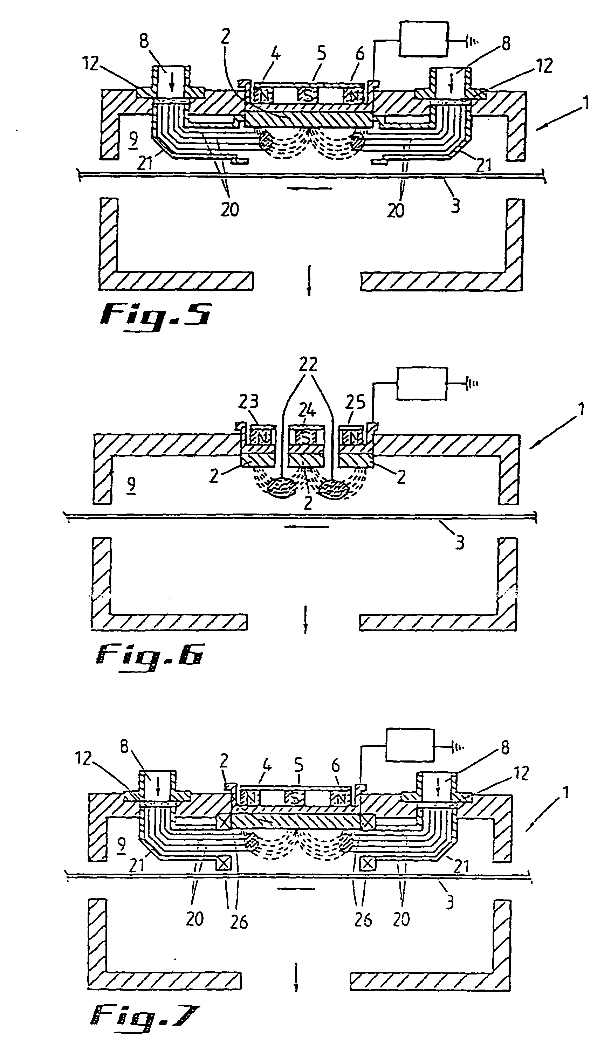

La figure 3 illustre la relation entre la tension de cible (V) et le courant (I) de cible. L'augmentation du taux d'ionisation appliquée au plasma par l'introduction du champ électromagnétique dans la gamme de fréquences micro-ondes permet donc de passer de la courbe de puissance $P_1$ (sans micro-onde) à la courbe de puissance $P_2$ (avec micro-onde). On constate donc qu'à vitesse de dépôt constante correspondant à un courant (I) constant, la tension V est plus faible du fait de la réduction de l'impédance du plasma mesurée entre cathode et anode.

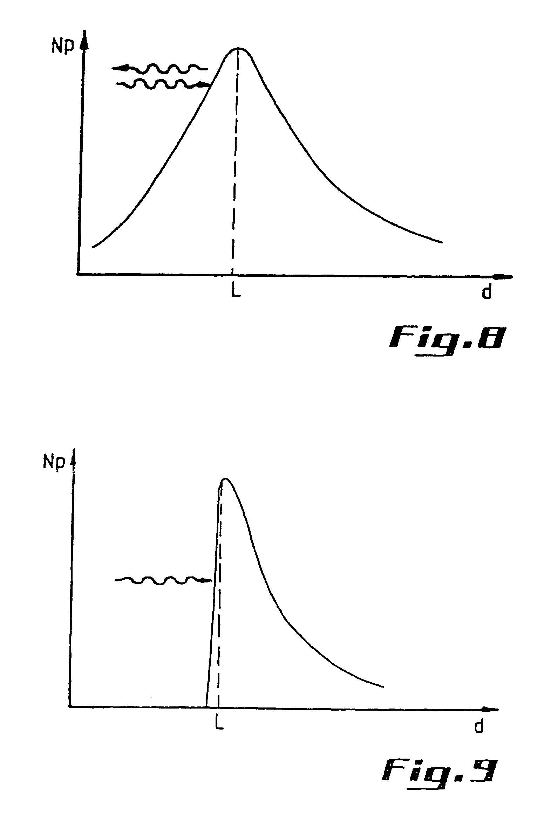

Toutefois, à puissance élevée la réflexion en retour vers la source génératrice de micro-onde de la puissance du champ électromagnétique pose un problème. A forte puissance, la densité du plasma augmente suffisamment pour que celui-ci devienne réfléchissant pour les micro-ondes ce qui limite en pratique le couplage d'énergie micro-ondes en dessous d'un certain seuil correspondant à une densité de plasma maximale de l'ordre de $10^{12}$ $cm^{-3}$. Des densités de plasma plus élevées et notamment de l'ordre de $10^{13}$ $cm^{-3}$ ne peuvent donc pas être obtenues au moyen des dispositifs connus. Le phénomène de réflexion des micro-ondes est illustré à la figure 8 où la densité $N_p$ du plasma est reprise en fonction de la distance d par rapport à la zone de résonance cyclotron des électrons. La zone de résonance étant considérée à la distance L, c'est-à-dire à la sortie du guide d'onde 21 (figure 5) qui conduit les micro-ondes vers ladite zone de résonance. La densité Np du plasma est maximale en L et décroît rapidement aussi bien à l'intérieur du guide d'onde que dans la chambre 9 due à la diffusion. Des micro-ondes qui traversent le guide d'onde peuvent dès lors être réfléchi par le plasma qui pénètre dans le guide d'onde lorsque la densité du plasma est élevée. Ces micro-ondes n'atteignent ainsi pas la zone de résonance cyclotron et le couplage d'énergie de ces micro-ondes réfléchies ne peut avoir lieu.

Dans les dispositifs conventionnels qui fonctionnent avec un couplage micro-ondes à 2.45GH$_z$ et qui font usages de guides d'ondes le problème réside dans le fait que le plasma qui a la possibilité de diffuser au-delà de la zone de résonance cyclotron des électrons devient une barrière d'autant plus réfléchissante pour les micro-ondes que la densité du plasma en dehors de la zone de résonance est élevée. C'est à cause de ce phénomène que la densité du plasma sature très rapidement à une valeur maximale inférieure à $10^{12}$ $cm^{-3}$.

Pour résoudre ce problème il est donc nécessaire de prévoir des moyens qui permettent que la densité $N_p$ du plasma décroît rapidement à l'intérieur du guide micro-onde, comme illustré à la figure 9. Lorsque la densité du plasma sera peu élevée à l'intérieur du guide micro-onde la probabilité de réflexion des micro-ondes sera également peu élevée et elles atteindront dès lors la zone de résonance cyclotron permettant ainsi le couplage.

Différentes solutions pour remédier à ce problème sont possibles.

Une première solution consiste à augmenter suffisamment la fréquence du champ électromagnétique pour que le plasma ne soit pas réfléchissant vis-à-vis du rayonnement électromagnétique dans la gamme de densité de plasma recherchée. A fréquence suffisamment élevée, le plasma sera "transparent" pour le rayonnement. En effet, la constante diélectrique du plasma est donnée par la formule suivante:

$$\varepsilon_p \approx \varepsilon_0 [1 - \frac{\omega_R^2}{\omega_{\mu w}^2}]$$

$$\omega_{\mu w} = 2\pi * f_{\mu w}$$

$$\omega_R = 2\pi * f_R$$

$$f_R = e^{2} * \frac{N_p}{\varepsilon_0 * m * 2\pi}$$

$N_p$, e, m, $\varepsilon_0$, $f_R$, $f_{\mu w}$ représentent respectivement la densité du plasma, la charge d'un électron, la masse d'un électron, la constante diélectrique du vide, la fréquence naturelle du plasma et la fréquence micro-onde. Lorsque $\tilde{\omega}_{\mu w} > \tilde{\omega}_R$ alors $0 < \varepsilon_p < 1$ et les micro-ondes peuvent traverser le plasma alors que dans le cas contraire où $\tilde{\omega}_{\mu w} < \tilde{\omega}_R$ la valeur de $\varepsilon_p$ sera nécessairement $\varepsilon_p < 0$, ce qui indique que le milieu devient réfléchissant pour les micro-ondes.

Le dispositif suivant l'invention utilise dès lors une source génératrice de micro-ondes ayant une fréquence d'excitation micro-ondes supérieure à 2,45 $GH_z$ et plus particulièrement comprise entre 2,45 $GH_z$ et 45 $GH_z$. Ainsi à une fréquence de 28,5 $GH_z$ correspond une densité de plasma $f_R = 10^{13}$ cm$^{-3}$. En augmentant la fréquence des micro-ondes il faut également accroître la valeur du champ d'induction afin de conserver la résonance cyclotron des électrons. Ainsi à 28,5 $GH_z$ la valeur du champ d'induction doit être de 9000 gauss pour obtenir un couplage par résonance cyclotron des électrons dans la décharge.

Une deuxième solution consiste à créer une barrière à la diffusion du plasma en dehors de la zone de résonance cyclotron (zone ECR) dans la direction du guide d'onde.

La figure 5 illustre à cette fin une forme de réalisation d'un dispositif suivant l'invention où des moyens pour limiter cette diffusion sont prévus. Ces moyens comprennent une juxtaposition d'éléments 20 distincts électriquement isolés entre-eux et par rapport au guide d'onde 21 qui relie la source 8 à la zone de résonance cyclotron. Ces éléments 20 sont de préférence disposés de façon perpendiculaire aux lignes de champ électrique du champ électromagnétique polarisé des micro-ondes dans le guide d'ondes. En plaçant ces éléments 20 perpendiculairement aux lignes de champ électrique du champ électromagnétique des micro-ondes les réflexions en retour vers la source sont minimalisées. Ces éléments sont à l'extrémité du guide d'onde de manière à y empêcher la diffusion du plasma dans le guide d'onde. Ces éléments permettent ainsi d'appliquer la puissance emportée par les micro-ondes directement dans la zone de résonance cyclotron des électrons en limitant sensiblement la réflexion, étant donné que dans cette zone où le couplage ECR à lieu, l'énergie du rayonnement micro-ondes peut être absorbée de manière importante, ce qui ne serait pas le cas pour un plasma de même densité situé en dehors de cette zone de résonance. Par adjonction de ces éléments au double système d'excitation (DC - micro-ondes), la densité du plasma peut atteindre des valeurs supérieures à $10^{12}$ cm$^{-3}$.

La position perpendiculaire des éléments 20 aux vecteurs du champ électrique du champ électromagnétique polarisé des micro-ondes dans le guide d'ondes est préférentielle mais d'autres positions sont également possibles, pour autant que ces éléments ne bloquent pas le passage des micro-ondes. Un angle différent à 90° n'empêche pas le fonctionnement du dispositif si ce dernier tolère un certain pourcentage de puissance réfléchie en retour vers la source de micro-ondes. Même sous un angle différent à 90° les éléments rempliront leur fonction qui consiste à diminuer considérablement la densité du plasma dans la direction du guide d'onde. Ces éléments sont par exemple formés par des lamelles, des barres ou des fils qui le cas échéant peuvent être de dimensions différentes.

La figure 6 illustre une autre forme de réalisation d'un dispositif où la puissance du rayonnement micro-ondes est appliquée directement dans la zone de résonance et à proximité de l'électrode aux moyens d'une ou plusieurs antennes 22. La puissance du champ électromagnétique micro-ondes est ainsi directement couplée dans la zone de résonance cyclotron des électrons. A ces formes préférentielles de réalisation peut encore s'ajouter la présence d'éléments modifiant la direction et la valeur du champ d'induction de manière à distribuer la zone de résonance de manière optimale soit à proximité des éléments qui empêchent la propagation du plasma entre la zone de résonance et le guide d'ondes, soit à proximité des antennes.

Comme illustré à la figure 6, les antennes de couplage 22 traversent les aimants 23, 24, et 25 qui produisent le champ magnétique ainsi que la cathode 2. L'une extrémité des antennes 22 aboutit directement dans la zone de résonance cyclotron, ce qui permet aux micro-ondes d'être ainsi directement injectées dans cette zone et d'éviter ainsi leur réflexion sur le plasma. Ces antennes sont disposées de telle façon qu'elles aboutissent directement dans la zone ECR à proximité de la cathode 2. Le fait que les antennes aboutissent directement dans la zone de résonance cyclotron fera que l'énergie du champ électromagnétique micro-ondes injectée est absorbé au voisinage immédiat de l'antenne. Dans ce cas, la formation de la zone de diffusion du plasma entre l'antenne et la zone de couplage est sans objet.

La figure 7 illustre un dispositif correspondant dans sa structure à celui illustré à la figure 5. Ce dispositif se distingue de celui de la figure 5 par la présence de lentilles magnétiques 26 servant également à limiter la diffusion du plasma en dehors de la zone de résonance cyclotron.

La figure 4 illustre une autre forme de réalisation d'un dispositif suivant l'invention. La source génératrice de micro-ondes est reliée à la chambre 9 à l'aide d'un guide d'onde 10 dans lequel est également montée une fenêtre 12 transparente aux micro-ondes. Le guide d'onde est suivi d'une zone 11 tampon (baffle) destinée à protéger la fenêtre 12 contre une contamination par la substance pulvérisée. La source de micro-onde est alors placée en aval de la zone tampon par rapport à la chambre 9.

Un gaz neutre, par exemple de l'argon, peut, le cas échéant, être introduit dans ladite zone afin d'accroître la protection contre toute contamination éventuelle de la source. De préférence, la zone présente une courbure, ce qui contribue davantage à la protection contre une contamination.

La cible ou cathode peut avoir différentes configurations. Ainsi, elle peut avoir soit une configuration plane rectangulaire ou circulaire, soit cylindrique ou avec une cathode creuse.

**Revendications**

1. Procédé pour la formation par pulvérisation cathodique d'un revêtement sur un substrat (3), ledit substrat étant placé dans une chambre (9) qui est ensuite amenée et maintenue durant ladite formation à une pression inférieure à 1 Pa et dans laquelle un plasma est généré, un champ électrique étant appliqué dans ladite chambre entre une cathode (2) à pulvériser et une anode, un champ magnétique ($\bar{B}$) sensiblement perpendiculaire au champ électrique étant également appliqué au moins au niveau de la cathode de manière à réaliser un circuit de confinement magnétique des électrons, et une zone de résonance cyclotron des électrons étant créée à proximité de la cathode en appliquant un champ électromagnétique dans la gamme de fréquences micro-ondes et dont la fréquence d'ondes correspond à la fréquence cyclotron des électrons dans le champ magnétique, **caractérisé en ce que** la fréquence d'onde des micro-ondes appliquée est supérieure à 2,45 $GH_z$ et inférieure à 45 $GH_z$, en particulier 28,5 $GH_z$, ledit plasma étant généré de telle façon à obtenir une densité supérieure à $10^{12}$ $cm^{-3}$.

2. Procédé de nettoyage par bombardement ionique d'un substrat, ledit substrat étant placé dans une chambre (9) qui est ensuite amenée et maintenue durant ledit nettoyage à une pression inférieure à 1 Pa et dans laquelle un plasma est généré, un champ électrique étant appliqué dans ladite chambre entre une anode (3) et ledit substrat servant de cathode (2), un champ magnétique ($\bar{B}$) sensiblement perpendiculaire au champ électrique étant également appliqué au moins au niveau de la cathode de manière à réaliser un circuit de confinement magnétique des électrons, et une zone de résonance cyclotron des électrons est créée à proximité de la cathode en appliquant un champ électromagnétique dans la gamme de fréquences micro-ondes et dont la fréquence d'ondes correspond à la fréquence cyclotron des électrons dans le champ magnétique, **caractérisé en ce que** la fréquence d'onde des micro-ondes appliquée est supérieure à 2,45 $GH_z$ et inférieure à 45 $GH_z$, en particulier 28,5 $GH_z$, ledit plasma étant généré de telle façon à obtenir une densité supérieure à $10^{12}$ $cm^{-3}$.

3. Dispositif de pulvérisation cathodique destiné à la formation d'un revêtement sur un substrat (2), comprenant une chambre (9) pourvue de premiers moyens agencés pour amener et maintenir, durant la formation, la chambre à une pression inférieure à 1 Pa, un premier support agencé pour porter une cathode à pulvériser et un second support agencé pour porter une anode ainsi que des deuxièmes moyens pour appliquer un champ électrique dans la chambre entre la cathode et l'anode, une source (4, 5, 6) de champ magnétique agencée pour appliquer dans la chambre au moins au niveau de la cathode un champ magnétique ($\vec{B}$) sensiblement perpendiculaire au champ électrique, de manière à réaliser un circuit de confinement magnétique des électrons, et un générateur de plasma agencé pour générer un plasma dans ladite chambre, ledit dispositif comportant également une source génératrice de micro-ondes (10) agencée pour introduire dans la chambre un champ électromagnétique dont la fréquence d'onde correspond à la fréquence cyclotron des électrons dans le champ magnétique et pour créer à proximité de la cathode une zone de résonance cyclotron des électrons, **caractérisé en ce que** ladite source génératrice de micro-onde est agencée pour produire un champ électromagnétique dont la fréquence d'onde est supérieure à 2.45 $GH_z$ et inférieure à 45 $GH_z$, en particulier 28,5 $GH_z$, ledit générateur de plasma étant agencé pour produire un plasma ayant une densité supérieure à $10^{12}$ $cm^{-3}$.

4. Dispositif de pulvérisation cathodique destiné à la formation d'un revêtement sur un substrat (3), comprenant une chambre (9) pourvue de premiers moyens agencés pour amener et maintenir, durant la formation, la chambre à une pression inférieure à 1 Pa, un premier support agencé pour porter une cathode à pulvériser et un second support agencé pour porter une anode ainsi que des deuxièmes moyens pour appliquer un champ électrique dans la chambre entre la cathode et l'anode, une source (4, 5, 6) de champ magnétique ($\vec{B}$) agencée pour appliquer dans la chambre au moins au niveau de la cathode un champ magnétique sensiblement perpendiculaire au champ électrique, de manière à réaliser un circuit de confinement magnétique des électrons, et un générateur de plasma agencé pour générer un plasma dans ladite chambre, ledit dispositif comportant également une source génératrice de micro-ondes (8) agencée pour introduire dans la chambre un champ électromagnétique dont la fréquence d'onde correspond à la fréquence cyclotron des électrons dans le champ magnétique et pour créer à proximité de la cathode une zone de résonance cyclotron des électrons, **caractérisé en ce qu'**il comporte des moyens (20) pour limiter la diffusion du plasma en dehors de ladite zone de résonance cyclotron dans la direction de ladite source, ledit générateur de plasma étant agencé pour produire un plasma ayant une densité supérieure à $10^{12}$ cm$^{-3}$

5. Dispositif de bombardement ionique destiné à nettoyer un substrat, comprenant une chambre (9) pourvue de troisièmes moyens agencés pour amener et maintenir, durant le nettoyage, la chambre à une pression inférieure à 1 Pa, un premier support agencé pour porter la cathode (2) formant le substrat à nettoyer et un second support agencé pour porter une anode (3) ainsi que des deuxièmes moyens pour appliquer un champ électrique dans la chambre entre la cathode et l'anode, une source (4, 5, 6) de champ magnétique ($\vec{B}$) agencée pour appliquer dans la chambre au moins au niveau de la cathode un champ magnétique sensiblement perpendiculaire au champ électrique, de manière à réaliser un circuit de confinement magnétique des électrons, et un générateur de plasma agencé pour générer un plasma dans ladite chambre, ledit dispositif comportant également une source (8) génératrice de micro-ondes agencée pour introduire dans la chambre un champ électromagnétique dont la fréquence d'onde correspond à la fréquence cyclotron des électrons dans le champ magnétique et pour créer à proximité de la cathode une zone de résonance cyclotron des électrons, **caractérisé en ce que** ladite source génératrice de micro-onde est agencée pour produire un champ électromagnétique dont la fréquence d'onde est supérieure à 2,45 GH$_z$ et inférieure à 45 GH$_z$, en particulier 28,5 GH$_z$, ledit générateur de plasma étant agencé pour produire un plasma ayant une densité supérieure à $10^{12}$ cm$^{-3}$.

6. Dispositif suivant la revendication 4, **caractérisé en ce que** lesdits moyens pour limiter la diffusion du plasma comportent des éléments (20) en forme d'écran électriquement isolés entre eux et par rapport à un guide d'onde reliant ladite source à ladite zone de résonance, lesdits éléments étant disposés dans le guide d'onde perpendiculairement aux lignes de champ électrique dudit champ électromagnétique.

7. Dispositif suivant l'une des revendications 3 à 6, **caractérisé en ce qu'**entre la source de micro-ondes et la chambre est aménagée une zone tampon destinée à protéger une zone de transmission de micro-ondes dans la chambre contre une contamination par la substance pulvérisée de la cathode.

8. Dispositif suivant la revendication 7, **caractérisé en ce que** la zone tampon présente une courbure par rapport à la chambre.

**Patentansprüche**

1. Verfahren zur Bildung einer Beschichtung auf einem Substrat (3) durch Kathodenzerstäubung, wobei das Substrat in einer Kammer (9) angeordnet ist, die dann auf einen Druck unter 1 Pa gebracht und auf diesem während der Bildung gehalten wird, und in der ein Plasma erzeugt wird, wobei ein elektrisches Feld in der Kammer zwischen einer zu zerstäubenden Kathode (2) und einer Anode angelegt wird, wobei ein im Wesentlichen auf das elektrische Feld senkrechtes Magnetfeld ($\vec{B}$) ebenfalls mindestens im Bereich der Kathode angelegt wird, um eine Schaltung zur magnetischen Eingrenzung der Elektronen zu herzustellen, und wobei eine Zyklotron-Resonanzzone der Elektronen in der Nähe der Kathode erzeugt wird, wobei ein elektromagnetisches Feld in dem Mikrowellenfrequenzbereich angelegt wird, dessen Wellenfrequenz der Zyklotronfrequenz der Elektronen in dem Magnetfeld entspricht, **dadurch gekennzeichnet, dass** die angelegte Wellenfrequenz der Mikrowellen größer als 2,45 GH$_z$ und kleiner als 45 GH$_z$, insbesondere 28,5 GH$_z$, ist, wobei das Plasma derart erzeugt wird, dass eine Dichte von mehr als $10^{12}$cm$^{-3}$ erzielt wird.

2. Verfahren zur Reinigung eines Substrats durch Ionenbeschuss, wobei das Substrat in einer Kammer (9) angeordnet ist, die dann auf einen Druck unter 1 Pa gebracht und auf diesem während der Reinigung gehalten wird, und in der ein Plasma erzeugt wird, wobei ein elektrisches Feld in der Kammer zwischen einer Anode (3) und dem Substrat, das als Kathode (2) dient, angelegt wird, wobei ein im Wesentlichen auf das elektrische Feld senkrechtes Magnetfeld ($\vec{B}$) ebenfalls mindestens im Bereich der Kathode angelegt wird, um eine Schaltung zur magnetischen Eingrenzung der Elektronen zu herzustellen, und wobei eine Zyklotron-Resonanzzone der Elektronen in der Nähe der Kathode erzeugt wird, wobei ein elektromagnetisches Feld in dem Mikrowellenfrequenzbereich angelegt wird, dessen Wellenfrequenz der Zyklotronfrequenz der Elektronen in dem Magnetfeld entspricht, **dadurch gekennzeichnet, dass** die angelegte Wellenfrequenz der Mikrowellen größer als 2,45 GH$_z$ und kleiner als 45 GH$_z$, insbesondere 28,5 GH$_z$, ist, wobei das Plasma derart erzeugt wird, dass eine Dichte von mehr als 10$^{12}$cm$^{-3}$ erzielt wird.

3. Vorrichtung zur Kathodenzerstäubung, die für die Bildung einer Beschichtung auf einem Substrat (2) bestimmt ist, umfassend eine Kammer (9), die mit ersten Mitteln, die derart angeordnet sind, dass während der Bildung die Kammer auf einem Druck unter 1 Pa gehalten wird, versehen ist, eine erste Stütze, die derart angeordnet ist, dass sie eine zu zerstäubende Kathode trägt, und eine zweite Stütze, die derart angeordnet ist, dass sie eine Anode trägt, sowie zweite Mittel, um ein elektrisches Feld in der Kammer zwischen der Kathode und der Anode anzulegen, eine Magnetfeldquelle (4, 5, 6), um in der Kammer mindestens im Bereich der Kathode ein im Wesentlichen auf das elektrische Feld senkrechtes Magnetfeld ($\vec{B}$) anzulegen, um eine Schaltung zur magnetischen Eingrenzung der Elektronen herzustellen, und einen Plasmagenerator, der derart angeordnet ist, dass er ein Plasma in der Kammer erzeugt, wobei die Vorrichtung auch eine Quelle zur Erzeugung von Mikrowellen (10) umfasst, die derart angeordnet ist, dass in die Kammer ein elektromagnetisches Feld eingeleitet wird, dessen Wellenfrequenz der Zyklotronfrequenz der Elektronen in dem Magnetfeld entspricht, und dass in der Nähe der Kathode eine Zyklotron-Resonanzzone der Elektronen erzeugt wird, **dadurch gekennzeichnet, dass** die Quelle zur Erzeugung von Mikrowellen derart angeordnet ist, dass ein elektromagnetisches Feld erzeugt wird, dessen Wellenfrequenz größer als 2,45 GH$_z$ und kleiner als 45 GH$_z$, insbesondere 28,5 GH$_z$, ist, wobei der Plasmagenerator derart angeordnet ist, dass ein Plasma mit einer Dichte von mehr als 10$^{12}$cm$^{-3}$ erzielt wird.

4. Vorrichtung zur Kathodenzerstäubung, die für die Bildung einer Beschichtung auf einem Substrat (3) bestimmt ist, umfassend eine Kammer (9), die mit ersten Mitteln, die derart angeordnet sind, dass sie während der Bildung die Kammer auf einen Druck unter 1 Pa bringen und auf diesem halten, versehen ist, eine erste Stütze, die derart angeordnet ist, dass sie eine zu zerstäubende Kathode trägt, und eine zweite Stütze, die derart angeordnet ist, dass sie eine Anode trägt, sowie zweite Mittel, um ein elektrisches Feld in der Kammer zwischen der Kathode und der Anode anzulegen, eine Quelle (4, 5, 6) für ein Magnetfeld ($\vec{B}$), die derart angeordnet ist, um in der Kammer mindestens im Bereich der Kathode ein im Wesentlichen auf das elektrische Feld senkrechtes Magnetfeld anzulegen, um eine Schaltung zur magnetischen Eingrenzung der Elektronen zu herzustellen, und einen Plasmagenerator, der derart angeordnet ist, dass er ein Plasma in der Kammer erzeugt, wobei die Vorrichtung auch eine Quelle zur Erzeugung von Mikrowellen (8) umfasst, die derart angeordnet ist, dass in die Kammer ein elektromagnetisches Feld eingeleitet wird, dessen Wellenfrequenz der Zyklotronfrequenz der Elektronen in dem Magnetfeld entspricht, und dass in der Nähe der Kathode eine Zyklotron-Resonanzzone der Elektronen erzeugt wird, **dadurch gekennzeichnet, dass** sie Mittel (20) umfasst, um die Diffusion des Plasmas außerhalb die Zyklotron-Resonanzzone in Richtung der Quelle zu begrenzen, wobei der Plasmagenerator derart angeordnet ist, dass er ein Plasma mit einer Dichte von mehr als 10$^{12}$cm$^{-3}$ erzeugt.

5. Verfahren zum Ionenbeschuss, das dazu bestimmt ist, ein Substrat zu reinigen, umfassend eine Kammer (9), die mit dritten Mitteln versehen ist, die derart angeordnet sind, dass sie während der Reinigung die Kammer auf einen Druck unter 1 Pa bringen und auf diesem halten, eine erste Stütze, die derart angeordnet ist, dass sie die das zu reinigende Substrat bildende Kathode (2) trägt, und eine zweite Stütze, die derart angeordnet ist, dass sie eine Anode (3) sowie zweite Mittel trägt, um ein elektrisches Feld in der Kammer zwischen der Kathode und der Anode anzulegen, eine Quelle (4, 5, 6) eines Magnetfeldes ($\vec{B}$), die derart angeordnet ist, dass sie in der Kammer im Bereich der Kathode ein im Wesentlichen auf das elektrische Feld senkrechtes Magnetfeld anlegt, um eine Schaltung zur magnetischen Eingrenzung der Elektronen herzustellen, und einen Plasmagenerator, der derart angeordnet ist, dass er ein Plasma in der Kammer erzeugt, wobei die Vorrichtung auch eine Quelle (8) zur Erzeugung von Mikrowellen umfasst, die derart vorgesehen ist, dass sie in die Kammer ein elektromagnetisches Feld einleitet, dessen Wellenfrequenz der Zyklotronfrequenz der Elektronen in dem Magnetfeld entspricht, und in der Nähe der Kathode eine Zyklotron-Resonanzzone der Elektronen im Magnetfeld erzeugt, **dadurch gekennzeichnet, dass** die Quelle zur Erzeugung von Mikrowellen derart angeordnet ist, dass sie ein elektromagnetisches Feld erzeugt, dessen Wellenfrequenz größer als 2,45 GH$_z$ und kleiner als 45 GH$_z$, insbesondere 28,5 GH$_z$, ist, wobei der Plasmagenerator derart vorgesehen ist, dass ein Plasma mit einer Dichte von mehr als 10$^{12}$cm$^{-3}$ erzeugt wird.

6. Vorrichtung nach Anspruch 4, **dadurch gekennzeichnet, dass** die Mittel zur Begrenzung der Diffusion des Plasmas Elemente (20) eines Bildschirms, die zueinander und in Bezug auf einen Wellenleiter, der die Quelle mit der Resonanzzone verbindet, elektrisch isoliert sind, umfassen, wobei diese Elemente in dem Wellenleiter senkrecht auf die elektrischen Feldlinien des elektromagnetischen Feldes angeordnet sind.

**7.** Vorrichtung nach einem der Ansprüche 3 bis 6, **dadurch gekennzeichnet, dass** zwischen der Mikrowellenquelle und der Kammer eine Pufferzone angeordnet ist, die dazu bestimmt ist, eine Übergangszone von Mikrowellen in die Kammer vor einer Kontaminierung durch die zerstäubte Substanz der Kathode zu schützen.

**8.** Vorrichtung nach Anspruch 7, **dadurch gekennzeichnet, dass** die Pufferzone eine Krümmung in Bezug auf die Kammer aufweist.

**Claims**

**1.** Method for the formation, by cathodic sputtering, of a coating on a substrate (3), the said substrate being placed in a chamber (9) which is then brought to and during said formation maintained at a pressure below 1 Pa and in which a plasma is generated, an electrical field being applied in the said chamber between a cathode (2) to be sputtered and an anode, a magnetic field ($\vec{B}$) substantially perpendicular to the electrical field also being applied at least to the cathode so as to produce a circuit for the magnetic confinement of the electrons, and a cyclotron resonance zone for the electrons being created close to the cathode by applying an electromagnetic field in the microwave frequency range and where the wave frequency corresponds to the cyclotron frequency of the electrons in the magnetic field, **characterised in that** the wave frequency of the microwaves supplied is above 2.45 GH$_z$ and below 45 GH$_z$ in particular 28.5 GH$_z$, the said plasma being generated so as to obtain a density above $10^{12}$ cm$^{-3}$.

**2.** Method of cleaning a substrate by ion bombardment, the said substrate being placed in a chamber (9) which is then brought to and during the said cleaning maintained at a pressure below 1 Pa and in which a plasma is generated, an electrical field being applied in the said chamber between an anode (3) and the said substrate serving as a cathode (2), a magnetic field ($\vec{B}$) substantially perpendicular to the electrical field also being applied at least at the cathode so as to produce a magnetic confinement circuit for the electrons, and a cyclotron resonance zone for the electrons is created close to the cathode by applying an electromagnetic field in the microwave frequency range and where the wave frequency corresponds to the cyclotron frequency of the electrons in the magnetic field, **characterised in that** the wave frequency of the microwaves applied is above 2.5 GH$_z$ and less than 45 GH$_z$, in particular 28.5 GH$_z$, the said plasma being generated so as to obtain a density greater than $10^{12}$ cm$^{-3}$.

**3.** Cathodic sputtering device intended for the formation of a coating on substrate (2), comprising a chamber (9) provided with first means arranged to bring and maintain the chamber, during the formation, to and at a pressure below 1 Pa, a first support arranged to carry a cathode to be sputtered and a second support arranged to carry an anode as well as second means for applying an electrical field in the chamber between the cathode and the anode, a magnetic field source (4, 5, 6) arranged so as to apply in the chamber at least at the cathode a magnetic field ($\vec{B}$) substantially perpendicular to the electrical field, so as to produce a magnetic confinement circuit for the electrons, and a plasma generator arranged so as to generate a plasma in the said chamber, the said device also comprising a microwave generating source (10) arranged to introduce into the chamber an electromagnetic field whose wave frequency corresponds to the cyclotron frequency of the electrons in the magnetic field and to create close to the cathode a cyclotron resonance zone for the electrons, **characterised in that** the said microwave generating source is arranged so as to produce an electromagnetic field whose wave frequency is above 2.45 GH$_z$ and below 45 GH$_z$, in particular 28.5 GH$_z$, the said plasma generator being arranged so as to produce a plasma having a density above $10^{12}$ cm$^{-3}$.

**4.** Cathodic sputtering device intended for the formation of a coating on a substrate (3), comprising a chamber (9) provided with first means arranged so as to bring and maintain the chamber, during the formation, to and at a pressure below 1 Pa, a first support arranged to carry a cathode to be sputtered and a second support arranged to carry an anode as well as second means for applying an electrical field in the chamber between the cathode and the anode, a source (4, 5, 6) of a magnetic field ($\vec{B}$) arranged so as to apply in the chamber at least at the cathode a magnetic field substantially perpendicular to the electrical field, so as to produce a magnetic confinement circuit for the electrons, and a plasma generator arranged so as to generate a plasma in the said chamber, the said device also comprising a microwave generating source (8) arranged to introduce into the chamber an electromagnetic field whose wave frequency corresponds to the cyclotron frequency of the electrons in the magnetic field and to create close to the cathode a cyclotron resonance zone for the electrons, **characterised in that** it comprises means (20) for limiting the diffusion of the plasma outside the said cyclotron resonance zone in the direction of the said source, the said plasma generator being arranged to produce a plasma having a density greater than $10^{12}$ cm$^{-3}$.

5. Ion bombardment device intended to clean a substrate, comprising a chamber (9) provided with third means arranged so as to bring and maintain the chamber, during the cleaning, to and at a pressure below 1 Pa, a first support arranged to carry the cathode (2) forming the substrate to be cleaned and a second support arranged to carry an anode (3), as well as second means for applying an electrical field in the chamber between the cathode and the anode, a source (4, 5, 6) of a magnetic field ($\vec{B}$) arranged to apply in the chamber, at least at the cathode, a magnetic field substantially perpendicular to the electrical field so as to produce a magnetic confinement circuit for the electrons, and a plasma generator arranged so as to generate a plasma in the said chamber, the said device also comprising a microwave generating source (8) arranged to introduce into the chamber an electromagnetic field whose wave frequency corresponds to the cyclotron frequency of the electrons in the magnetic field and to create close to the cathode a cyclotron resonance zone for the electrons, **characterised in that** the said microwave generating source is arranged so as to produce an electromagnetic field whose wave frequency is above 2.45 GH$_z$ and below 45 GH$_z$, in particular 28.5 GH$_z$, the said plasma generator being arranged so as to produce a plasma having a density above $10^{12}$ cm$^{-3}$.

6. Device according to Claim 4, **characterised in that** the said means for limiting the diffusion of the plasma comprise elements (20) in the form of a screen electrically insulated from each other and with respect to a waveguide connecting the said source to the said resonance zone, the said elements being disposed in the waveguide perpendicular to the electrical field lines of the said electromagnetic field.

7. Device according to one of Claims 3 to 6, **characterised in that**, between the microwave source and the chamber, a buffer zone is provided intended to protect a microwave transmission zone in the chamber against contamination by the sputtered substance of the cathode.

8. Device according to Claim 7, **characterised in that** the buffer zone has a curvature with respect to the chamber.

**Fig.1**

**Fig.2**

**Fig.3**

**Fig.4**

*Fig.5*

*Fig.6*

*Fig.7*

**Fig.8**

**Fig.9**